# EUROPEAN PATENT SPECIFICATION

(11) **EP 2 319 176 B1**
(45) Date of publication and mention of the grant of the patent: **16.05.2012**
(21) Application number: 09789446.3
(22) Date of filing: 02.02.2009
(51) Int. Cl.: H03G 3/34

(54) **METHOD AND APPARATUS FOR REDUCING AUDIO ARTIFACTS**
VERFAHREN UND VORRICHTUNG ZUR VERRINGERUNG VON AUDIOARTEFAKTEN
PROCÉDÉ ET APPAREIL PERMETTANT DE RÉDUIRE DES ARTEFACTS AUDIO

(30) Priority: 24.07.2008 US 83454 P; 29.10.2008 US 260825
(43) Date of publication of application: 11.05.2011
(73) Proprietor: QUALCOMM Incorporated, San Diego, CA 92121 (US)
(72) Inventor: MAJUMDAR, Somdeb, San Diego California 92121 (US); GARUDADRI, Harinath, San Diego California 92121 (US)
(74) Representative: Carstens, Dirk Wilhelm
(86) International application number: PCT/US2009/032846
(87) International publication number: WO 2010/011362

(56) References cited:
- EP-A- 0 651 521
- EP-A- 1 195 895
- EP-A- 1 881 602
- WO-A-93/20622
- US-A- 3 188 571
- US-A- 3 569 840
- US-A- 3 873 926
- US-A- 4 041 390
- US-A- 4 388 731
- US-A- 4 731 873
- US-A1- 2007 005 160

## Description

### Claim of Priority

The present Application for Patent claims priority to Provisional Application No. 61/083,454 entitled "METHOD AND APPARATUS FOR REDUCING AUDIO ARTIFACTS" filed July 24, 2008, and assigned to the assignee hereof.

### BACKGROUND

The present disclosure relates generally to communication systems, and more particularly, to concepts and techniques for reducing audio artifacts.

Peer-to-peer networks are commonly used for connecting wireless nodes via adhoc connections. These networks differ from the traditional client-server model where communications are usually with a central server. A peer-to-peer network has only equal peer nodes that communicate directly with one another. Such networks are useful for many purposes. A peer-to-peer network may be used, for example, as a consumer electronic wire replacement system for short range or indoor applications. These networks are sometimes referred to as Wireless Personal Area Networks (WPAN) and are useful for efficiently transferring video, audio, voice, text, and other media between wireless nodes over a short distance. A WPAN may provide connectivity for nodes in a home or a small office or may be used to provide connectivity for nodes carried by a person. In a typical scenario, a WPAN may provide connectivity for nodes within a range on the order of tens of meters.

In the applications requiring any use of audio signals (e.g., cell phone, headset), many audio codecs fail to remove the presence of audible quantization noise when the audio signal level is close to zero. One way to mitigate this problem is to use a nonuniform quantizer model.

Depending on hardware limitations, however, such non-linear quantizers may not have sufficient resolution for low-amplitude signals to suppress audible quantization noise. This problem is particularly significant when the codec employs noise-shaping techniques (e.g., sigma-delta modulation) using lower-than-adequate over-sampling ratios (OSR). The quantization noise resulting from low OSRs is particularly audible to a listener in the absence of adequate loudness levels in the signal of interest.

Consequently, there exists a need for a technique to attenuate audio artifacts in communication nodes. Document US 2007/0005160 A1 describes a digital audio receiver, including automute detection circuitry. Document WO 93/20622 describes a squelch detector.

### SUMMARY

The present invention is defined by the appended claims. According to an aspect of the disclosure, an apparatus for processing signals includes a receiver configured to receive an audio signal having a plurality of audio artifacts, and an audio circuit configured to reduce the audio artifacts during at least a portion of a time period as a function of an energy level of the audio signal during that time period.

According to another aspect of the disclosure, a method for processing signals includes receiving an audio signal having a plurality of audio artifacts, and reducing the audio artifacts during at least a portion of a time period as a function of an energy level of the audio signal during that time period.

According to a further aspect of the disclosure, an apparatus for processing signals includes means for receiving an audio signal having a plurality of audio artifacts, and means for reducing the audio artifacts during at least a portion of a time period as a function of an energy level of the audio signal during that time period.

According to yet a further aspect of the disclosure, a computer program product for processing signals includes computer-readable medium comprising instructions executable to receive an audio signal having a plurality of audio artifacts, and reduce the audio artifacts during at least a portion of a time period as a function of an energy level of the audio signal during that time period.

According to another aspect of the disclosure, a headset includes a receiver configured to receive an audio signal having a plurality of audio artifacts, an audio circuit configured to reduce the audio artifacts during at least a portion of a time period as a function of an energy level of the audio signal during that time period, and a transducer configured to provide an audible output based on the audio signal processed by the audio circuit.

According to yet another aspect of the disclosure, a watch includes a receiver configured to receive an audio signal having a plurality of audio artifacts, an audio circuit configured to reduce the audio artifacts during at least a portion of a time period as a function of an energy level of the audio signal during that time period, and a display configured to provide a visual output based on the audio signal processed by the audio circuit.

According to yet a further aspect of the disclosure, a medical monitor includes a receiver configured to receive an audio signal having a plurality of audio artifacts, wherein the audio signal is generated by a sensor, and an audio circuit configured to reduce the audio artifacts during at least a portion of a time period as a function of an energy level of the audio signal during that time period.

It is understood that other aspects of the invention will become readily apparent to those skilled in the art from the following detailed description, wherein it is shown and described only various aspects of the invention by way of illustration. As will be realized, the invention is capable of other and different aspects and its several details are capable of modification in various other respects, all without departing from the scope of the invention. Accordingly, the drawings and detailed description are to be regarded as illustrative in nature and not as restrictive.

### BRIEF DESCRIPTION OF THE DRAWINGS

These and other sample aspects of the disclosure will be described in the detailed description and the appended claims that follow, and in the accompanying drawings, wherein:

FIG. 1 is a conceptual diagram illustrating an example of a wireless communications system;

FIG. 2 is a schematic block diagram illustrating an example of a receiver;

FIG. 3 is a flowchart depicting an example of a signal artifact attenuation process in a receiver; and

FIG. 4 is a block diagram illustrating an example of the functionality of an apparatus.

In accordance with common practice the various features illustrated in the drawings may be simplified for clarity. Thus, the drawings may not depict all of the components of a given apparatus (e.g., node) or method. In addition, like reference numerals may be used to denote like features throughout the specification and figures.

### DETAILED DESCRIPTION

Various aspects of the disclosure are described below. It should be apparent that the teachings herein may be embodied in a wide variety of forms and that any specific structure, function, or both being disclosed herein are merely representative. Based on the teachings herein one skilled in the art should appreciate that an aspect disclosed herein may be implemented independently of any other aspects and that two or more of these aspects may be combined in various ways. For example, an apparatus may be implemented or a method may be practiced using any number of the aspects set forth herein. In addition, such an apparatus may be implemented or such a method may be practiced using other structure, functionality, or structure and functionality in addition to or other than one or more of the aspects set forth herein. An aspect may comprise one or more elements of a claim.

Several aspects of a receiver will now be presented. The receiver may be part of a mobile or fixed node, such as a phone (e.g., cellular phone), a personal digital assistant (PDA), an entertainment device (e.g., a music or video device), a headset (e.g., headphones, an earpiece, etc.), a microphone, a medical sensing device (e.g., a biometric sensor, a heart rate monitor, a pedometer, an EKG device, a smart bandage, etc.), a user I/O device (e.g., a watch, a remote control, a light switch, a keyboard, a mouse, etc.), a medical monitor that may receive data from the medical sensing device, an environment sensing device (e.g., a tire pressure monitor), a computer, a point-of-sale device, an entertainment device, a hearing aid, a set-top box, or any other suitable device. The node may include various components in addition to the receiver. By way of example, a wireless headset may include a transducer configured to provide an audio output to a user, a wireless watch may include a user interface configured to provide an indication to a user, and a wireless sensing device may include a sensor configured to provide an audio output to a user.

The receiver may also be part of an access device (e.g., a Wi-Fi access point) that provides backhaul services to other nodes. Such an access device may provide, by way of example, connectivity to another network (e.g., a wide area network such as the Internet or a cellular network) via a wired or wireless communication link.

In many of the applications described above, the receiver may be part of a node that transmits as well as receives. Such a node would therefore require a transmitter, which may be a separate component or integrated with the receiver into a single component known as a "transceiver." As those skilled in the art will readily appreciate, the various concepts described throughout this disclosure are applicable to any suitable receiver function, regardless of whether the receiver is a stand-alone node, integrated into a transceiver, or part of a node in a wireless communications system.

In the following detailed description, various aspects of a receiver will be described for reducing or removing signal artifacts (e.g., audio artifacts) from received signals. Some aspects of the receiver will be described in the context of a WPAN supporting Ultra-Wideband (UWB), but as those skilled in the art will readily appreciate that the various aspects presented throughout this disclosure are likewise applicable to receivers for other radio technologies including Bluetooth, WiMax, and Wi-Fi, just to name a few. These aspects may also be extended to wired technologies including, by way of example, cable modem, Digital Subscriber Line, (DSL), Ethernet, and any other suitable communications technology.

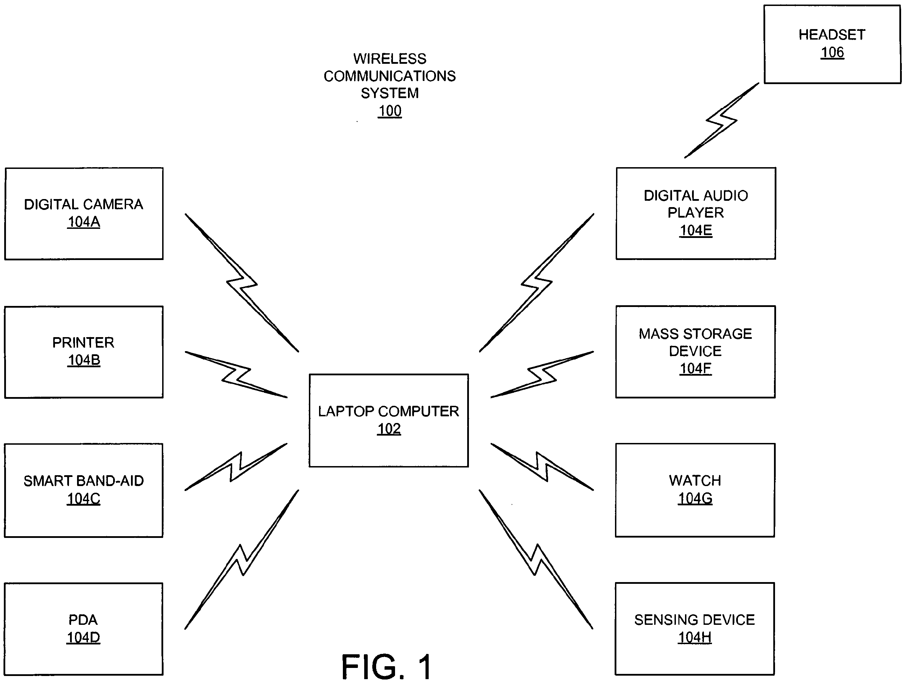

An example of a UWB WPAN with wireless nodes that may benefit by incorporating various aspects of a receiver presented throughout this disclosure is shown in FIG. 1. UWB is a common technology for high speed short range communications (e.g., home and office networking applications) as well as low speed long range communications. UWB is defined as any radio technology having a spectrum that occupies a bandwidth greater than 20 percent of the center frequency, or a bandwidth of at least 500 MHz. Two radio technologies have recently emerged to support UWB. One is based on Impulse Radio techniques extended to direct sequence spread spectrum. The other radio technology is based on Orthogonal Frequency Division Multiplexing (OFDM).

The WPAN 100 is shown with a laptop computer 102 in communication with various other wireless nodes 104. In this example, the computer 102 may receive digital photos from a digital camera 104A, send documents to a printer 104B for printing, communicate with a smart band-aid 104C, synch-up with e-mail on a Personal Digital Assistant (PDA) 104D, transfer music files to a digital audio player (e.g., MP3 player) 104E, back up data and files to a mass storage device 104F, set the time on a watch 104G, and receive data from a sensing device 104H (e.g., a medical device such as a biometric sensor, a heart rate monitor, a pedometer, an EKG device, etc.). Also shown is a headset 106 (e.g., headphones, earpiece, etc.) that receives audio from the digital audio player 104E.

In one configuration of the WPAN 100, the computer 102 provides an access point to a Wide Area Network (WAN) (i.e., a wireless network covering a regional, nationwide, or even a global region). One common example of a WAN is the Internet. Another example of a WAN is a cellular network that supports CDMA2000, a telecommunications standard that uses Code Division Multiple Access (CDMA) to send voice, data, and signaling between mobile subscribers. Another example of a WWAN is a cellular network that provides broadband Internet access to mobile subscribers, such as Evolution-Data Optimized (EV-DO) or Ultra Mobile Broadband (UMB), both of which are part of the CDMA2000 family of air interface standards. Alternatively, or in addition to, the computer 102 may have a UWB connection to an Ethernet modem, or some other interface to a Local Area Network (LAN) (i.e., a network generally covering tens to a few hundred meters in homes, offices buildings, coffee shops, transportation hubs, hotels, etc.).

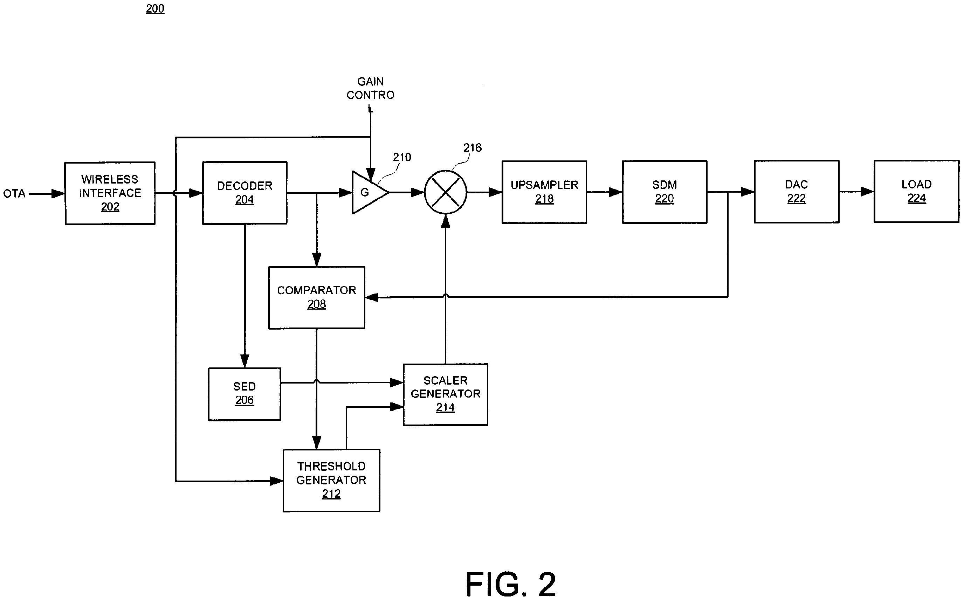

Various aspects of a receiver will now be presented with reference to FIG. 2. As discussed earlier, these aspects may be well suited for wireless nodes in a UWB WPAN such as the one described in connection with FIG. 1. However, as those skilled in the art will readily appreciate, these aspects may be extended to receivers for other radio and wired technologies.

The receiver 200 is shown with a wireless interface 202 that implements the physical (PHY) layer and the Medium Access Control (MAC) layer. The PHY layer implements all the physical and electrical specifications to interface the receiver to the wireless medium. More specifically, the PHY layer is responsible for demodulating an RF carrier to recover an audio signal, as well as providing other processing functions such as analog/digital conversion, timing and frequency estimation, channel estimation, forward error correction (e.g., Turbo decoding), etc. The MAC layer manages the audio content that is across the PHY layer making it possible for several nodes to communicate with the receiver 200. The implementation of the wireless interface 202 is well within the capabilities of one skilled in the art, and therefore, will not be described any further.

The audio signal recovered by the wireless interface 202 may be encoded according to a given audio file format or streaming audio format. In such a case, an audio decoder 204 may be used to reconstruct the audio signal from the encoded transmission recovered by the wireless interface 202. In one example of a receiver, the audio decoder 204 may be configured to reconstruct an audio signal encoded with a backward adaptive gain ranged algorithm; however, the audio decoder 204 may be configured to handle other encoding schemes. Those skilled in the art will be readily able to implement the appropriate audio decoder 204 for any particular application. The audio decoder 204 may be a stand-alone component as shown in FIG. 2, or integrated into an audio codec in the case where the receiver is part of a node that transmits as well as receives.

The decoded audio signal may be provided to a gain controller 210 for volume control. The gain controller 210 may be any type of device (e.g., an amplifier) that is capable of controlling the power or amplitude of the audio signal. A gain control input to the gain controller 210 allows the volume of the audio signal to be adjusted.

The output from the gain controller 210 may be provided to an attenuator 216. The attenuator 216 may be any electronic device that is capable of reducing the amplitude or power of a signal without appreciably distorting its waveform (e.g., a multiplier). In a manner to be described in greater detail later, the attenuator 216 is used to attenuate the audio signal during audio silence, which tends to reduce audio artifacts.

The output from the attenuator 216 may be provided to an upsampler 218. The upsampler 218 is configured to sample the audio signal at a frequency much greater than the Nyquist frequency (two times the bandwidth of the audio signal). This process tends to reduce aliasing, which might otherwise distort the audio signal. The sampling frequency may be fixed or adaptively controlled for performance optimization.

The upsampled audio signal may be provided to a noise shaping filter, such as a sigma delta modulator (SDM) 220. The SDM 220 reduces quantization noise in the audio band by distributing it over a larger spectrum. The distribution of the quantization noise may be shaped with reduced noise at low frequencies and increased noise at higher frequencies, where it can be filtered.

The output from the SDM 220 may be provided to a Digital-to-Analog Converter (DAC) 222. The DAC converts the audio signal into an analog signal and provides the audio power amplifier functionality to drive a load 224 (e.g., a speaker).

As discussed earlier, an attenuator 216 is used to attenuate the audio signal during periods of audio silence. In one configuration of a receiver, this may be accomplished with a Signal Energy Detector (SED) 206, a threshold generator 212, a scaler generator 214 and a comparator 208.

The comparator 208, in addition to receiving the signal outputted from the decoder 204, receives a feedback signal that has already been processed downstream by the gain controller 210, the upsampler 218, and the SDM 220. The comparator 208 compares the decoded signal with the feed back signal and generates a quality metric signal based on the difference between the two signals. The comparator 208 then transmits the quality metric signal to the threshold generator 212.

The threshold generator 212 receives both the gain control signal and the quality metric signal, and, based on the two signals, generates an energy threshold signal representing a level of energy below which the received signal is designated as "low energy" or "silence" (e.g., audio silence). The threshold generator 212 then transmits the energy threshold signal to the scaler generator 214.

The SED 206 detects and measures an energy level of the signal received from the decoder 204. The SED 206 may be any device capable of sensing signal power or amplitude levels at high resolution. Based on the detected signal energy levels, the SED 206 generates an energy level signal, and transmits the energy level signal to the scaler generator 214.

The scaler generator is configured to receive the energy threshold signal generated by the threshold generator 214 and the energy level signal generated by the SED 206. Based on these two signals, the scaler generator 214 maps quantization noise of the received signal during long-periods of "silence" or "low energy" to zero. This is achieved by using an estimate of, for example, sound pressure levels from previous samples, as well as short "look ahead" to ramp up quickly once the received signal attains appreciable energy. To estimate the energy levels from previous levels, the scaler generator 214 computes an average energy value (Eₚₐₛₜ) of the received signal over previous N samples. To perform the short "look ahead," the scaler generator 214 is configured to "look ahead" M samples, and compute the average energy value over the M samples (E_{future}).

The scaler generated by the scaler generator 214 has a value that is based on the comparison between the threshold signal value and the average energy values Eₚₐₛₜ and E_{future}. The scaler value may be either a zero (0) or a one (1). The scaler is varied between 0 and 1 via ramping up from 0 to 1 or ramping down from 1 to 0. For example, if either of the average energy values Eₚₐₛₜ and E_{future} are less than the threshold signal value, the scaler generator 214 will maintain the scaler value at 0, if it was previously at 0, or ramp down the scaler value from 1 to 0, if it was previously at 1. Similarly, if either of the average energy values Eₚₐₛₜ and E_{future} is equal to or greater than the threshold signal value, the scaler generator 214 will maintain the scaler value at 1, if it was previously at 1, or ramp up the scaler value from 0 to 1, if it was previously at 0. The duration of the ramp up and the ramp down may be determined based on the desired quality of attenuation of the received signal. For example, the ramp up duration may be significantly shorter than the ramp down duration in order to ensure minimal loss in the received signal content.

In addition to adjusting the scaler value based on the average energy levels Eₚₐₛₜ and E_{future}, the scaler generator 214 may adjust the scaler value depending on the temporal location of the received signal in a predetermined time period. For example, the scaler generator 214 may ramp down the scaler value from 1 to 0 at the beginning of the time period and ramp up the scaler value from 0 to 1 at the end of the time period.

Once the scaler generator 214 generates the appropriate scaler, it is configured to transmit the scaler to the attenuator 216. As mentioned before, the attenuator 216 attenuates the received signal based on the scaler value. For example, if the scaler value is 0, indicating low average energy level (e.g., audio silence), the received signal is attenuated to null, ensuring that no signal artifacts are transmitted through the receiver. Conversely, if the scaler value is 1, indicating a sufficient average energy level, the received signal is transmitted through the attenuator 216 without being attenuated.

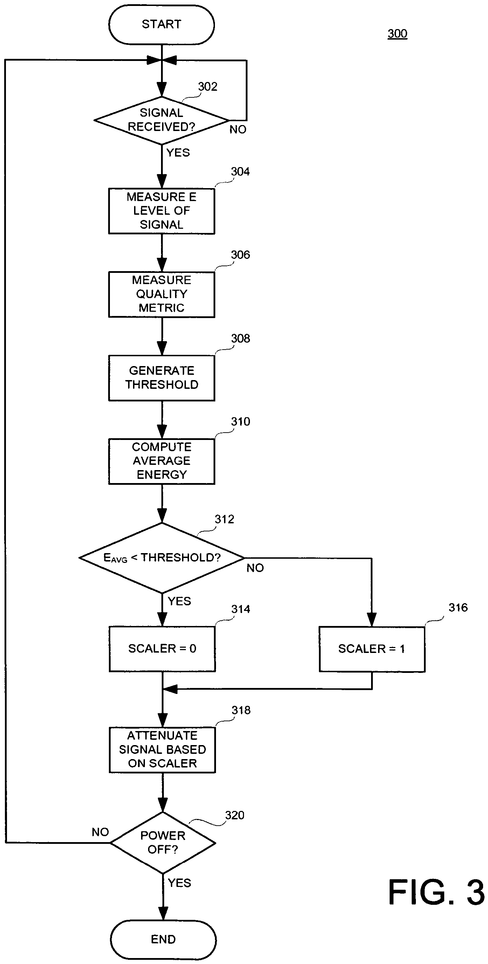

An example of a signal artifact attenuation process will now be presented with reference to the flow chart illustrated in FIG. 3. As shown in FIG. 3, in block 302, a determination is made as to whether a signal is received. If a signal is not received, the process loops back until a signal is received. If a signal is received, the process proceeds to block 304.

In block 304, an energy level of the received signal is measured, and the process proceeds to block 306. For example, as shown in FIG. 2, the SED 206 detects and measures the energy level of the received signal.

In block 306, a quality metric of the received signal is measured, and the process proceeds to block 308. For example, as shown in FIG. 2, the comparator 208 generates the quality metric signal based on the received and feedback signals.

In block 308, a threshold signal is generated, and the process proceeds to block 310. For example, in FIG. 2, the threshold generator 212 generates a threshold signal based on the gain control signal and the quality metric signal.

In block 310, an average energy level is computed, and the process proceeds to block 312. For example, in FIG. 2, the scaler generator computes the average energy levels Eₚₐₛₜ and E_{future}, and generates a scaler based on these energy levels.

In block 312, a determination is made as to whether the computed average energy level value is less than the threshold signal value. If so, the process proceeds to block 314. If not, the process proceeds to block 316.

In block 314, a scaler value is set to 0, and the process proceeds to block 318. At block 316, the scaler value is set to 1, and the process likewise proceeds to block 318.

In block 318, the received signal is attenuated based on the scaler value, and the process proceeds to block 320 where a determination is made as to whether the receiver 200 is powered off. If the receiver 200 is not powered off, the process returns to block 302. Otherwise, the process ends.

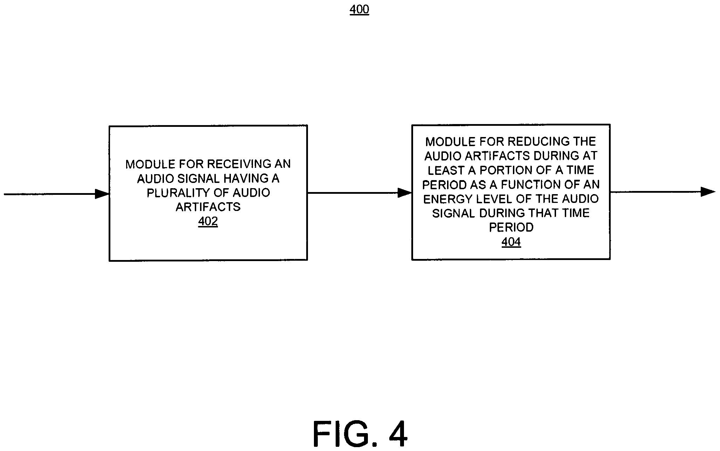

FIG. 4 is a block diagram illustrating an example of the functionality of an apparatus. In this example, the apparatus 400 includes a module 402 for receiving an audio signal having a plurality of audio artifacts, and a module 404 for reducing the audio artifacts during at least a portion of a time period as a function of an energy level of the audio signal during that time period. The module 402 may be implemented by the wireless interface 202 (see FIG. 2) described above or by some other suitable means. Likewise, the module 404 may be implemented at least by the scaler generator 214 and the attenuator 216 described above or by some other suitable means.

The components described herein may be implemented in a variety of ways. For example, an apparatus may be represented as a series of interrelated functional blocks that may represent functions implemented by, for example, one or more integrated circuits (e.g., an ASIC) or may be implemented in some other manner as taught herein. As discussed herein, an integrated circuit may include a processor, software, other components, or some combination thereof. Such an apparatus may include one or more modules that may perform one or more of the functions described above with regard to various figures.

As noted above, in some aspects these components may be implemented via appropriate processor components. These processor components may in some aspects be implemented, at least in part, using structure as taught herein. In some aspects a processor may be adapted to implement a portion or all of the functionality of one or more of these components.

As noted above, an apparatus may comprise one or more integrated circuits. For example, in some aspects a single integrated circuit may implement the functionality of one or more of the illustrated components, while in other aspects more than one integrated circuit may implement the functionality of one or more of the illustrated components.

In addition, the components and functions described herein may be implemented using any suitable means. Such means also may be implemented, at least in part, using corresponding structure as taught herein. For example, the components described above may be implemented in an "ASIC" and also may correspond to similarly designated "means for" functionality. Thus, in some aspects one or more of such means may be implemented using one or more of processor components, integrated circuits, or other suitable structure as taught herein.

Also, it should be understood that any reference to an element herein using a designation such as "first," "second," and so forth does not generally limit the quantity or order of those elements. Rather, these designations may be used herein as a convenient method of distinguishing between two or more elements or instances of an element. Thus, a reference to first and second elements does not mean that only two elements may be employed there or that the first element must precede the second element in some manner. Also, unless stated otherwise a set of elements may comprise one or more elements. In addition, terminology of the form "at least one of: A, B, or C" used in the description or the claims means "A or B or C or any combination thereof."

Those of skill in the art would understand that information and signals may be represented using any of a variety of different technologies and techniques. For example, data, instructions, commands, information, signals, bits, symbols, and chips that may be referenced throughout the above description may be represented by voltages, currents, electromagnetic waves, magnetic fields or particles, optical fields or particles, or any combination thereof.

Those of skill would further appreciate that any of the various illustrative logical blocks, modules, processors, means, circuits, and algorithm steps described in connection with the aspects disclosed herein may be implemented as electronic hardware (e.g., a digital implementation, an analog implementation, or a combination of the two, which may be designed using source coding or some other technique), various forms of program or design code incorporating instructions (which may be referred to herein, for convenience, as "software" or a "software module"), or combinations of both. To clearly illustrate this interchangeability of hardware and software, various illustrative components, blocks, modules, circuits, and steps have been described above generally in terms of their functionality. Whether such functionality is implemented as hardware or software depends upon the particular application and design constraints imposed on the overall system. Skilled artisans may implement the described functionality in varying ways for each particular application, but such implementation decisions should not be interpreted as causing a departure from the scope of the present disclosure.

The various illustrative logical blocks, modules, and circuits described in connection with the aspects disclosed herein may be implemented within or performed by an integrated circuit ("IC"), an access terminal, or an access point. The IC may comprise a general purpose processor, a digital signal processor (DSP), an application specific integrated circuit (ASIC), a field programmable gate array (FPGA) or other programmable logic device, discrete gate or transistor logic, discrete hardware components, electrical components, optical components, mechanical components, or any combination thereof designed to perform the functions described herein, and may execute codes or instructions that reside within the IC, outside of the IC, or both. A general purpose processor may be a microprocessor, but in the alternative, the processor may be any conventional processor, controller, microcontroller, or state machine. A processor may also be implemented as a combination of computing devices, e.g., a combination of a DSP and a microprocessor, a plurality of microprocessors, one or more microprocessors in conjunction with a DSP core, or any other such configuration.

It is understood that any specific order or hierarchy of steps in any disclosed process is an example of a sample approach. Based upon design preferences, it is understood that the specific order or hierarchy of steps in the processes may be rearranged while remaining within the scope of the present disclosure. The accompanying method claims present elements of the various steps in a sample order, and are not meant to be limited to the specific order or hierarchy presented.

The steps of a method or algorithm described in connection with the aspects disclosed herein may be embodied directly in hardware, in a software module executed by a processor, or in a combination of the two. A software module (e.g., including executable instructions and related data) and other data may reside in a data memory such as RAM memory, flash memory, ROM memory, EPROM memory, EEPROM memory, registers, a hard disk, a removable disk, a CD-ROM, or any other form of computer-readable storage medium known in the art. A sample storage medium may be coupled to a machine such as, for example, a computer/processor (which may be referred to herein, for convenience, as a "processor") such the processor can read information (e.g., code) from and write information to the storage medium. A sample storage medium may be integral to the processor. The processor and the storage medium may reside in an ASIC. The ASIC may reside in user equipment. In the alternative, the processor and the storage medium may reside as discrete components in user equipment. Moreover, in some aspects any suitable computer-program product may comprise a computer-readable medium comprising codes (e.g., executable by at least one computer) relating to one or more of the aspects of the disclosure. In some aspects a computer program product may comprise packaging materials.

The previous description is provided to enable any person skilled in the art to practice the various aspects described herein. Various modifications to these aspects will be readily apparent to those skilled in the art, and the generic principles defined herein may be applied to other aspects. Thus, the claims are not intended to be limited to the aspects shown herein, but is to be accorded the full scope consistent with the language claims, wherein reference to an element in the singular is not intended to mean "one and only one" unless specifically so stated, but rather "one or more." All structural and functional equivalents to the elements of the various aspects described throughout this disclosure that are known or later come to be known to those of ordinary skill in the art are expressly incorporated herein by reference and are intended to be encompassed by the claims.

## Claims

1. An apparatus for processing signals, comprising:
a receiver configured to receive an audio signal having a plurality of audio artifacts; and
an audio circuit configured to reduce the audio artifacts during at least a portion of a time period as a function of an energy level of the audio signal during that time period based on the energy level of the audio signal indicating a level of energy below a dynamic energy threshold during that time period,
wherein the audio circuit further comprises an attenuator configured to scale the audio signal to reduce the audio artifacts during at least said portion of the time period,
wherein the audio circuit further comprises a comparator configured to compare the audio signal with a feed back signal obtained from the scaled audio signal and configured to generate a quality metric based on the difference between the audio signal and the feed back signal, and
wherein the audio circuit further comprises a threshold generator configured to generate the energy threshold as a function of the quality metric.

2. The apparatus of claim 1, wherein the audio circuit further comprises a scaler generator configured to provide a scaler to the attenuator to scale the audio signal during at least said portion of the time period.

3. The apparatus of claim 2, wherein the scaler generator is further configured to generate the scaler by comparing the average energy level of the audio signal during at least said portion of the time period to the energy threshold.

4. The apparatus of claim 1, further comprising a gain controller configured to apply a gain to the audio signal, wherein the threshold generator is further configured to generate the dynamic threshold as a function of the gain.

5. The apparatus of claim 2, wherein the scaler generator is further configured to ramp down the scaler from a first state to a second state at the beginning of the time period and ramp up the scaler from the second state to the first state at the end of the time period.

6. The apparatus of claim 5, wherein the attenuator is further configured to not attenuate the audio signal if the scaler is in the first state and completely attenuate the audio signal if the scaler is in the second state.

7. The apparatus of claim 5, wherein the attenuator comprises a multiplier, and wherein the first state of the scaler is 1 and the second state of the scaler is 0.

8. The apparatus of claim 3, wherein the scaler generator is further configured to generate the scaler as a function of the average energy level over a portion of the audio signal previously provided to the attenuator.

9. The apparatus of claim 8, wherein the scaler generator is further configured to ramp down the scaler in response to the average energy level of said portion of the audio signal dropping below the energy threshold.

10. The apparatus of claim 2, wherein the scaler generator is further configured to generate the scaler as a function of the average energy level over a portion of the audio signal which has not yet been provided to the attenuator.

11. The apparatus of claim 10, wherein the scaler generator is further configured to ramp up the scaler in response to the average energy level of said portion of the audio signal rising above the energy threshold.

12. A method for processing signals, comprising:
receiving an audio signal having a plurality of audio artifacts; and
reducing the audio artifacts during at least a portion of a time period as a function of an energy level of the audio signal during that time period based on the energy level of the audio signal indicating a level of energy below a dynamic energy threshold during that time period,
wherein reducing the audio artifacts further comprises scaling the audio signal to reduce the audio artifacts during at least said portion of the time period,
wherein reducing the audio artifacts further comprises comparing the audio signal with a feed back signal obtained from the scaled audio signal,
wherein reducing the audio artifacts further comprises generating a quality metric based on the difference between the audio signal and the feed back signal, and
wherein reducing the audio artifacts further comprises generating the energy threshold as a function of the quality metric.

13. The method of claim 12, further comprising providing a scaler to scale the audio signal during at least said portion of the time period.

14. The method of claim 13, further comprising generating the scaler by comparing the average energy level of the audio signal during at least said portion of the time period to the energy threshold.

15. The method of claim 12, further comprising applying a gain to the audio signal, and generating the dynamic threshold as a function of the gain.

16. The method of claim 13, further comprising ramping down the scaler from a first state to a second state at the beginning of the time period, and ramping up the scaler from the second state to the first state at the end of the time period.

17. The method of claim 16, not attenuating the audio signal if the scaler is in the first state, and completely attenuating the audio signal if the scaler is in the second state.

18. The method of claim 16, wherein the first state of the scaler is 1, and the second state of the scaler is 0.

19. The method of claim 13, further comprising generating the scaler as a function of the average energy level over a portion of the audio signal previously provided to the attenuator.

20. The method of claim 19, further comprising ramping down the scaler in response to the average energy level of said portion of the audio signal dropping below the energy threshold.

21. The method of claim 13, further comprising generating the scaler as a function of the average energy level over a portion of the audio signal which has not yet been provided to the attenuator.

22. The method of claim 21, further comprising ramping up the scaler in response to the average energy level of said portion of the audio signal rising above the energy threshold.

23. An apparatus for processing signals, comprising:
means for receiving an audio signal having a plurality of audio artifacts;
means for reducing the audio artifacts during at least a portion of a time period as a function of an energy level of the audio signal during that time period based on the energy level of the audio signal indicating a level of energy below a dynamic energy threshold during that time period;
means for scaling the audio signal to reduce the audio artifacts during at least said portion of the time period;
means for comparing the audio signal with a feed back signal obtained from the scaled audio signal and for generating a quality metric based on the difference between the audio signal and the feed back signal; and
means for generating the energy threshold, wherein the energy threshold is generated as a function of the quality metric.

24. The apparatus of claim 23, further comprising means for providing a scaler to scale the audio signal during at least said portion of the time period.

25. The apparatus of claim 24, further comprising means for generating the scaler by comparing the average energy level of the audio signal during at least said portion of the time period to the energy threshold.

26. The apparatus of claim 23, further comprising means for applying a gain to the audio signal, and means for generating the dynamic threshold as a function of the gain.

27. The apparatus of claim 24, further comprising means for ramping down the scaler from a first state to a second state at the beginning of the time period, and ramping up the scaler from the second state to the first state at the end of the time period.

28. The apparatus of claim 27, further comprising means for not attenuating the audio signal if the scaler is in the first state, and completely attenuating the audio signal if the scaler is in the second state.

29. The apparatus of claim 27, wherein the first state of the scaler is 1, and the second state of the scaler is 0.

30. The apparatus of claim 24, further comprising means for generating the scaler as a function of the average energy level over a portion of the audio signal previously provided to the attenuator.

31. The apparatus of claim 30, further comprising means for ramping down the scaler in response to the average energy level of said portion of the audio signal dropping below the energy threshold.

32. The apparatus of claim 24, further comprising means for generating the scaler as a function of the average energy level over a portion of the audio signal which has not yet been provided to the attenuator.

33. The apparatus of claim 32, further comprising means for ramping up the scaler in response to the average energy level of said portion of the audio signal rising above the energy threshold.

34. A computer program product for processing signals comprising:
computer-readable medium comprising instructions to execute the steps of any of the Claims 12 to 22.

35. The apparatus of any of Claims 1 to 11, configured to function as a headset, further comprising a transducer configured to provide an audible output based on the audio signal processed by the audio circuit.

36. The apparatus of any of Claims 1 to 11, configured to function as a watch, further comprising a display configured to provide a visual output based on the audio signal processed by the audio circuit.

37. The apparatus of any of Claims 1 to 11, configured to function as a medical monitor, wherein the audio signal is generated by a sensor.

## Patentansprüche

1. Eine Vorrichtung zum Verarbeiten von Signalen, die Folgendes aufweist:
einen Empfänger, der konfiguriert ist, um ein Audiosignal mit einer Vielzahl von Audioartefakten zu empfangen; und
eine Audioschaltung, die konfiguriert ist, um die Audioartefakte während zumindest eines Abschnitts einer Zeitperiode als eine Funktion eines Energiepegels des Audiosignals während dieser Zeitperiode zu reduzieren, und zwar basierend auf dem Energiepegel des Audiosignals, der einen Energiepegel unterhalb einer dynamischen Energieschwelle während dieser Zeitperiode anzeigt,
wobei die Audioschaltung weiter ein Dämpfungsglied aufweist, das konfiguriert ist, um das Audiosignal zu skalieren, um die Audioartefakte während mindestens eines Abschnitts der Zeitperiode zu reduzieren,
wobei die Audioschaltung weiter ein Vergleichsglied aufweist, das konfiguriert ist, um das Audiosignal mit einem Feedback- bzw. Rückkoppelungssignal zu vergleichen, das aus dem skalierten Audiosignal erhalten wird und das konfiguriert ist, um eine Qualitätsmetrik basierend auf der Differenz zwischen dem Audiosignal und dem Feedback-Signal zu generieren, und
wobei die Audioschaltung weiter einen Schwellengenerator aufweist, der konfiguriert ist, um die Energieschwelle als eine Funktion der Qualitätsmetrik zu generieren.

2. Vorrichtung nach Anspruch 1, wobei die Audioschaltung weiter einen Skalierfaktorgenerator aufweist, der konfiguriert ist, um einen Skalierfaktor für das Dämpfungsglied vorzusehen, um das Audiosignal während zumindest eines Abschnittes der Zeitperiode zu skalieren.

3. Vorrichtung nach Anspruch 2, wobei der Skalierfaktorgenerator weiter konfiguriert ist, um den Skalierfaktor durch Vergleichen des durchschnittlichen Energiepegels des Audiosignals während mindestens eines Abschnitts der Zeitperiode mit der Energieschwelle zu generieren.

4. Vorrichtung nach Anspruch 1, die weiter eine Verstärkungssteuervorrichtung bzw. einen Verstärkungscontroller aufweist, der konfiguriert ist, um eine Verstärkung auf das Audiosignal anzuwenden, wobei der Schwellengenerator weiter konfiguriert ist, um eine dynamische Schwelle als eine Funktion der Verstärkung zu generieren.

5. Vorrichtung nach Anspruch 2, wobei der Skalierfaktorgenerator weiter konfiguriert ist, um einen Skalierfaktor von einem ersten Zustand in einen zweiten Zustand zu Beginn der Zeitperiode herunterzufahren und den Skalierfaktor von dem zweiten Zustand in den ersten Zustand am Ende der Zeitperiode hochzufahren.

6. Vorrichtung nach Anspruch 5, wobei das Dämpfungsglied weiter konfiguriert ist, um das Audiosignal nicht zu dämpfen, wenn der Skalierfaktor in dem ersten Zustand ist und das Audiosignal vollständig zu dämpfen, wenn der Skalierfaktor in dem zweiten Zustand ist.

7. Vorrichtung nach Anspruch 5, wobei das Dämpfungsglied ein Multiplikationsglied aufweist, und wobei der erste Zustand des Skalierfaktors 1 ist und der zweite Zustand des Skalierfaktors 0 ist.

8. Vorrichtung nach Anspruch 3, wobei der Skalierfaktorgenerator weiter konfiguriert ist, um den Skalierfaktor als eine Funktion des durchschnittlichen Energiepegels über einen Abschnitt des Audiosignals zu generieren, das zuvor an das Dämpfungsglied geliefert wurde.

9. Vorrichtung nach Anspruch 8, wobei der Skalierfaktorgenerator weiter konfiguriert ist, um den Skalierfaktor ansprechend auf den durchschnittlichen Energiepegel des Abschnittes des Audiosignals herunterzufahren, der unter die Energieschwelle fällt.

10. Vorrichtung nach Anspruch 2, wobei der Skalierfaktorgenerator weiter konfiguriert ist, um den Skalierfaktor als eine Funktion des durchschnittlichen Energiepegels über einen Abschnitt des Audiosignals zu generieren, der noch nicht an das Dämpfungsglied geliefert wurde.

11. Vorrichtung nach Anspruch 10, wobei der Skalierfaktorgenerator weiter konfiguriert ist, um den Skalierfaktor ansprechend auf den durchschnittlichen Energiepegel des Abschnittes des Audiosignals hochzufahren, der über der Energieschwelle liegt.

12. Ein Verfahren zum Verarbeiten von Signalen, das Folgendes aufweist:
Empfangen eines Audiosignals mit einer Vielzahl von Audioartefakten; und
Reduzieren der Audioartefakte während zumindest eines Abschnitts einer Zeitperiode als eine Funktion eines Energiepegels des Audiosignals während dieser Zeitperiode basierend auf dem Energiepegel des Audiosignals, der einen Energiepegel unterhalb einer dynamischen Energieschwelle während dieser Zeitperiode anzeigt,
wobei das Reduzieren der Audioartefakte weiter das Skalieren des Audiosignals aufweist, um die Audioartefakte während mindestens eines Abschnittes der Zeitperiode zu reduzieren,
wobei das Reduzieren der Audioartefakte weiter das Vergleichen des Audiosignals mit einem Feedback-Signal aufweist, das aus dem skalierten Audiosignal empfangen wird,
wobei das Reduzieren der Audioartefakte weiter das Generieren einer Qualitätsmetrik basierend auf der Differenz zwischen dem Audiosignal und dem Feedback-Signal aufweist, und
wobei das Reduzieren der Audioartefakte weiter das Generieren der Energieschwelle als eine Funktion der Qualitätsmetrik aufweist.

13. Verfahren nach Anspruch 12, das weiter das Vorsehen eines Skalierfaktors aufweist, um das Audiosignal während mindestens eines Abschnittes der Zeitperiode zu skalieren.

14. Verfahren nach Anspruch 13, das das Generieren des Skalierfaktors aufweist, und zwar durch Vergleichen des durchschnittlichen Energiepegels des Audiosignals während zumindest dem Abschnitt der Zeitperiode mit der Energieschwelle.

15. Verfahren nach Anspruch 12, das weiter das Anwenden einer Verstärkung auf das Audiosignal aufweist, und das Generieren der dynamischen Schwelle als eine Funktion der Verstärkung.

16. Verfahren nach Anspruch 13, das weiter das Herunterfahren des Skalierfaktors von einem ersten Zustand in einen zweiten Zustand zu Beginn der Zeitperiode aufweist, und das Hochfahren des Skalierfaktors von dem zweiten Zustand in den ersten Zustand am Ende der Zeitperiode.

17. Verfahren nach Anspruch 16, wobei das Audiosignal nicht gedämpft wird, wenn der Skalierfaktor im ersten Zustand ist, und wobei das Audiosignal vollständig gedämpft wird, wenn der Skalierfaktor im zweiten Zustand ist.

18. Verfahren nach Anspruch 16, wobei der erste Zustand des Skalierfaktors 1 ist und der zweite Zustand des Skalierfaktors 0 ist.

19. Verfahren nach Anspruch 13, das weiter das Generieren des Skalierfaktors als eine Funktion des durchschnittlichen Energiepegels über einen Abschnitt des Audiosignals aufweist, der zuvor an das Dämpfungsglied geliefert wurde.

20. Verfahren nach Anspruch 19, das weiter das Herunterfahren des Skalierfaktors ansprechend auf den durchschnittlichen Energiepegel des Abschnittes des Audiosignals aufweist, der unter die Energieschwelle fällt.

21. Verfahren nach Anspruch 13, das weiter das Generieren des Skalierfaktors als eine Funktion des durchschnittlichen Energiepegels über einen Abschnitt des Audiosignals aufweist, der noch nicht an das Dämpfungsglied geliefert wurde.

22. Verfahren nach Anspruch 21, das weiter das Hochfahren des Skalierfaktors ansprechend auf den durchschnittlichen Energiepegel des Abschnittes des Audiosignals aufweist, der über der Energieschwelle liegt.

23. Vorrichtung zur Verarbeitung von Signalen, die Folgendes aufweist:
Mittel zum Empfangen eines Audiosignals mit einer Vielzahl von Audioartefakten; und
Mittel zum Reduzieren der Audioartefakte während zumindest eines Abschnitts einer Zeitperiode als eine Funktion eines Energiepegels des Audiosignals während dieser Zeitperiode basierend auf dem Energiepegel des Audiosignals, der einen Energiepegel unterhalb einer dynamischen Energieschwelle während dieser Zeitperiode anzeigt,
Mittel zum Skalieren des Audiosignals, um die Audioartefakte während mindestens eines Abschnittes der Zeitperiode zu reduzieren,
Mittel zum Vergleichen des Audiosignals mit einem Feedback-Signal, das aus dem skalierten Audiosignal empfangen wird und zum Generieren einer Qualitätsmetrik basierend auf der Differenz zwischen dem Audiosignal und dem Feedback-Signal, und
Mittel zum Generieren der Energieschwelle, wobei die Energieschwelle als eine Funktion der Qualitätsmetrik generiert wird.

24. Vorrichtung nach Anspruch 23, die weiter Mittel zum Vorsehen eines Skalierfaktors aufweist, um das Audiosignal während mindestens eines Abschnittes der Zeitperiode zu skalieren.

25. Vorrichtung nach Anspruch 24, die weiter Mittel zum Generieren des Skalierfaktors durch Vergleichen des durchschnittlichen Energiepegels des Audiosignals während zumindest dem Abschnitt der Zeitperiode mit der Energieschwelle aufweist.

26. Vorrichtung nach Anspruch 23, die weiter Mittel zum Anwenden einer Verstärkung auf das Audiosignal aufweist, und Mittel zum Generieren der dynamischen Schwelle als eine Funktion der Verstärkung.

27. Vorrichtung nach Anspruch 24, die weiter Mittel zum Herunterfahren des Skalierfaktors von einem ersten Zustand in einen zweiten Zustand zu Beginn der Zeitperiode aufweist, und zum Hochfahren des Skalierfaktors von dem zweiten Zustand in den ersten Zustand am Ende der Zeitperiode.

28. Vorrichtung nach Anspruch 27, die weiter Mittel aufweist, um das Audiosignal nicht zu dämpfen, wenn der Skalierfaktor im ersten Zustand ist, und um das Audiosignal vollständig zu dämpfen, wenn der Skalierfaktor im zweiten Zustand ist.

29. Vorrichtung nach Anspruch 27, wobei der erste Zustand des Skalierfaktors 1 ist und der zweite Zustand des Skalierfaktors 0 ist.

30. Vorrichtung nach Anspruch 24, die weiter Mittel aufweist zum Generieren des Skalierfaktors als eine Funktion des durchschnittlichen Energiepegels über einen Abschnitt des Audiosignals, das zuvor an das Dämpfungsglied geliefert wurde.

31. Vorrichtung nach Anspruch 30, die weiter Mittel aufweist zum Herunterfahren des Skalierfaktors ansprechend auf den durchschnittlichen Energiepegel des Abschnittes des Audiosignals, der unter die Energieschwelle fällt.

32. Vorrichtung nach Anspruch 24, die weiter Mittel aufweist zum Generieren des Skalierfaktors als eine Funktion des durchschnittlichen Energiepegels über einen Abschnitt des Audiosignals, der noch nicht an das Dämpfungsglied geliefert wurde.

33. Vorrichtung nach Anspruch 32, die weiter Mittel zum Hochfahren des Skalierfaktors ansprechend auf den durchschnittlichen Energiepegel des Abschnittes des Audiosignals aufweist, der über der Energieschwelle liegt.

34. Ein Computerprogrammprodukt zum Verarbeiten von Signalen, das Folgendes aufweist:
ein computerlesbares Medium, das Instruktionen aufweist, um die Schritte nach einem der Ansprüche 12 bis 22 durchzuführen.

35. Vorrichtung nach einem der Ansprüche 1 bis 11, die konfiguriert ist, um als ein Headset zu arbeiten, die weiter einen Transducer aufweist, der konfiguriert ist, um eine hörbare Ausgabe basierend auf dem Audiosignal vorzusehen, das von der Audioschaltung verarbeitet wird.

36. Vorrichtung nach einem der Ansprüche 1 bis 11, die konfiguriert ist, um als eine Uhr zu arbeiten, die weiter eine Anzeige aufweist, die konfiguriert ist, um eine visuelle Ausgabe basierend auf dem Audiosignal vorzusehen, das von der Audioschaltung verarbeitet wird.

37. Vorrichtung nach Anspruch 1 bis 11, die konfiguriert ist, um als eine medizinische Überwachungsvorrichtung zu arbeiten, wobei das Audiosignal durch einen Sensor generiert wird.

## Revendications

1. Dispositif pour traiter des signaux, comprenant :
un récepteur agencé pour recevoir un signal audio comportant une pluralité d'artéfacts audio ; et
un circuit audio agencé pour réduire les artéfacts audio pendant au moins une partie d'une période temporelle en fonction d'un niveau d'énergie du signal audio pendant cette période temporelle sur la base du fait que le niveau d'énergie du signal audio indique un niveau d'énergie en-dessous d'un seuil d'énergie dynamique pendant cette période temporelle,
dans lequel le circuit audio comprend en outre un atténuateur agencé pour appliquer un facteur d'échelle au signal audio pour réduire les artéfacts audio pendant au moins ladite partie de la période temporelle,
dans lequel le circuit audio comprend en outre un comparateur agencé pour comparer le signal audio à un signal de contre-réaction obtenu à partir du signal audio mis à l'échelle et agencé pour générer une métrique de qualité sur la base de la différence entre le signal audio et le signal de contre-réaction, et
dans lequel le circuit audio comprend en outre un générateur de seuil agencé pour générer le seuil d'énergie en fonction de la métrique de qualité.

2. Dispositif selon la revendication 1, dans lequel le circuit audio comprend en outre un générateur de facteur d'échelle agencé pour fournir un facteur d'échelle à l'atténuateur pour mettre le signal audio à l'échelle pendant au moins ladite partie de la période temporelle.

3. Dispositif selon la revendication 2, dans lequel le générateur de facteur d'échelle est en outre agencé pour générer le facteur d'échelle en comparant le niveau d'énergie moyen du signal audio pendant au moins ladite partie de la période temporelle au seuil d'énergie.

4. Dispositif selon la revendication 1, comprenant en outre un contrôleur de gain agencé pour appliquer un gain au signal audio, le générateur de seuil étant en outre agencé pour générer le seuil dynamique en fonction du gain.

5. Dispositif selon la revendication 2, dans lequel le générateur de facteur d'échelle est en outre agencé pour faire descendre le facteur d'échelle d'un premier état vers un deuxième état au début de la période temporelle et pour faire monter le facteur d'échelle du deuxième état vers le premier état à la fin de la période temporelle.

6. Dispositif selon la revendication 5, dans lequel l'atténuateur est en outre agencé pour ne pas atténuer le signal audio si le facteur d'échelle est dans le premier état et pour atténuer complètement le signal audio si le facteur d'échelle est dans le deuxième état.

7. Dispositif selon la revendication 5, dans lequel l'atténuateur comprend un multiplieur, et dans lequel le premier état du facteur d'échelle est 1 et le deuxième état du facteur d'échelle est 0.

8. Dispositif selon la revendication 3, dans lequel le générateur de facteur d'échelle est en outre agencé pour générer le facteur d'échelle en fonction du niveau d'énergie moyen sur une partie du signal audio fournie précédemment à l'atténuateur.

9. Dispositif selon la revendication 8, dans lequel le générateur de facteur d'échelle est en outre agencé pour faire descendre le facteur d'échelle en réponse au fait que le niveau d'énergie moyen de ladite partie du signal audio tombe en-dessous du seuil d'énergie.

10. Dispositif selon la revendication 2, dans lequel le générateur de facteur d'échelle est en outre agencé pour générer le facteur d'échelle en fonction du niveau d'énergie moyen sur une partie du signal audio qui n'a pas encore été fournie à l'atténuateur.

11. Dispositif selon la revendication 10, dans lequel le générateur de facteur d'échelle est en outre agencé pour faire monter le facteur d'échelle en réponse au fait que le niveau d'énergie moyen de ladite partie du signal audio monte au-dessus du seuil d'énergie.

12. Procédé pour traiter des signaux, comprenant les étapes suivantes :
recevoir un signal audio comportant une pluralité d'artéfacts audio ; et
réduire les artéfacts audio pendant au moins une partie d'une période temporelle en fonction d'un niveau d'énergie du signal audio pendant cette période temporelle sur la base du fait que le niveau d'énergie du signal audio indique un niveau d'énergie en-dessous d'un seuil d'énergie dynamique pendant cette période temporelle,
dans lequel la réduction des artéfacts audio comprend en outre l'application d'un facteur d'échelle au signal audio pour réduire les artéfacts audio pendant au moins ladite partie de la période temporelle,
dans lequel la réduction des artéfacts audio comprend en outre la comparaison du signal audio à un signal de contre-réaction obtenu à partir du signal audio mis à l'échelle,
dans lequel la réduction des artéfacts audio comprend en outre la génération d'une métrique de qualité sur la base de la différence entre le signal audio et le signal de contre-réaction, et
dans lequel la réduction des artéfacts audio comprend en outre la génération du seuil d'énergie en fonction de la métrique de qualité.

13. Procédé selon la revendication 12, comprenant en outre la fourniture d'un facteur d'échelle pour mettre à l'échelle le signal audio pendant au moins ladite partie de la période temporelle.

14. Procédé selon la revendication 13, comprenant en outre la génération du facteur d'échelle en comparant le niveau d'énergie moyen du signal audio pendant au moins ladite partie de la période temporelle au seuil d'énergie.

15. Procédé selon la revendication 12, comprenant en outre l'application d'un gain au signal audio, et la génération du seuil dynamique en fonction du gain.

16. Procédé selon la revendication 13, comprenant en outre de faire monter le facteur d'échelle d'un premier état vers un deuxième état au début de la période temporelle, et de faire descendre le facteur d'échelle du deuxième état vers le premier état à la fin de la période temporelle.

17. Procédé selon la revendication 16, dans lequel on n'atténue pas le signal audio si le facteur d'échelle est dans le premier état, et on atténue complètement le signal audio si le facteur d'échelle est dans le deuxième état.

18. Procédé selon la revendication 16, dans lequel le premier état du facteur d'échelle est 1, et le deuxième état du facteur d'échelle est 0.

19. Procédé selon la revendication 13, comprenant en outre la génération du facteur d'échelle en fonction du niveau d'énergie moyen sur une partie du signal audio fournie précédemment à l'atténuateur.

20. Procédé selon la revendication 19, comprenant en outre de faire descendre le facteur d'échelle en réponse au fait que le niveau d'énergie moyen de ladite partie du signal audio tombe en-dessous du seuil d'énergie.

21. Procédé selon la revendication 13, comprenant en outre la génération du facteur d'échelle en fonction du niveau d'énergie moyen sur une partie du signal audio qui n'a pas encore été fournie à l'atténuateur.

22. Procédé selon la revendication 21, comprenant en outre de faire monter le facteur d'échelle en réponse au fait que le niveau d'énergie moyen de ladite partie du signal audio monte au dessus du seuil d'énergie.

23. Dispositif pour traiter des signaux, comprenant :
des moyens pour recevoir un signal audio comportant une pluralité d'artéfacts audio ;
des moyens pour réduire les artéfacts audio pendant au moins une partie d'une période temporelle en fonction d'un niveau d'énergie du signal audio pendant cette période temporelle sur la base du fait que le niveau d'énergie du signal audio indique un niveau d'énergie en-dessous d'un seuil d'énergie dynamique pendant cette période temporelle ;
des moyens pour mettre le signal audio à l'échelle pour réduire les artéfacts audio pendant au moins ladite partie de la période temporelle ;
des moyens pour comparer le signal audio à un signal de contre-réaction obtenu à partir du signal audio mis à l'échelle et pour générer une métrique de qualité sur la base de la différence entre le signal audio et le signal de contre-réaction ; et
des moyens pour générer le seuil d'énergie, le seuil d'énergie étant généré en fonction de la métrique de qualité.

24. Dispositif selon la revendication 23, comprenant en outre des moyens pour fournir un facteur d'échelle pour mettre à l'échelle le signal audio pendant au moins ladite partie de la période temporelle.

25. Dispositif selon la revendication 24, comprenant en outre des moyens pour générer le facteur d'échelle en comparant le niveau d'énergie moyen du signal audio pendant au moins ladite partie de la période temporelle au seuil d'énergie.

26. Dispositif selon la revendication 23, comprenant en outre des moyens pour appliquer un gain au signal audio, et des moyens pour générer le seuil dynamique en fonction du gain.

27. Dispositif selon la revendication 24, comprenant en outre des moyens pour faire descendre le facteur d'échelle d'un premier état vers un deuxième état au début de la période temporelle, et pour faire monter le facteur d'échelle du deuxième état vers le premier état à la fin de la période temporelle.

28. Dispositif selon la revendication 27, comprenant en outre des moyens pour ne pas atténuer le signal audio si le facteur d'échelle est dans le premier état, et pour atténuer complètement le signal audio si le facteur d'échelle est dans le deuxième état.

29. Dispositif selon la revendication 27, dans lequel le premier état du facteur d'échelle est 1, et le deuxième état du facteur d'échelle est 0.

30. Dispositif selon la revendication 24, comprenant en outre des moyens pour générer le facteur d'échelle en fonction du niveau d'énergie moyen sur une partie du signal audio fournie précédemment à l'atténuateur.

31. Dispositif selon la revendication 30, comprenant en outre des moyens pour faire descendre le facteur d'échelle en réponse au fait que le niveau d'énergie moyen de ladite partie du signal audio tombe en dessous du seuil d'énergie.

32. Dispositif selon la revendication 24, comprenant en outre des moyens pour générer le facteur d'échelle en fonction du niveau d'énergie moyen sur une partie du signal audio qui n'a pas encore été fournie à l'atténuateur.

33. Dispositif selon la revendication 32, comprenant en outre des moyens pour faire monter le facteur d'échelle en réponse au fait que le niveau d'énergie moyen de ladite partie du signal audio monte au-dessus du seuil d'énergie.

34. Produit programme d'ordinateur pour traiter des signaux, comprenant :
un support lisible par un ordinateur comprenant des instructions pour exécuter les étapes de l'une quelconque des revendications 12 à 22.

35. Dispositif selon l'une quelconque des revendications 1 à 11, agencé pour fonctionner en tant que casque d'écoute, comprenant en outre un transducteur agencé pour fournir une sortie audible sur la base du signal audio traité par le circuit audio.

36. Dispositif selon l'une quelconque des revendications 1 à 11, agencé pour fonctionner en tant que montre, comprenant en outre un afficheur agencé pour fournir une sortie visuelle sur la base du signal audio traité par le circuit audio.

37. Dispositif selon l'une quelconque des revendications 1 à 11, agencé pour fonctionner en tant que moniteur médical, dans lequel le signal audio est généré par un capteur.
